# EUROPÄISCHE PATENTANMELDUNG

(11) **EP 4 300 556 A1**
(43) Veröffentlichungstag der Anmeldung: **03.01.2024**
(21) Anmeldenummer: 22181251.4
(22) Anmeldetag: 27.06.2022
(51) Int. Cl.: H01L 21/67, H01L 21/683

(54) **ABDECKUNG FÜR EIN REINIGUNGSMODUL ZUM REINIGEN EINER HALBLEITERSCHEIBE UND VERFAHREN ZUM REINIGEN EINER HALBLEITERSCHEIBE IN EINER REINIGUNGSSTRASSE**

(71) Anmelder: Siltronic AG, 81677 München (DE)
(72) Erfinder: Möckel, Bertram, 09599 Freiberg (DE); Rothenaicher, Simon, 84567 Erlbach (DE); Schwab, Günter, 84524 Neuötting (DE)
(74) Vertreter: Staudacher, Wolfgang

(57) **Zusammenfassung**

Abdeckung für ein Reinigungsmodul und Verfahren zum Reinigen einer Halbleiterscheibe, in dem die Halbleiterscheibe vertikal ausgerichtet während eines Reinigungsschritts mit einer Flüssigkeit behandelt wird, die Abdeckung umfassend einen Grundkörper mit keilförmigem Querschnitt, einen Abdichtrahmen zum Absetzen der Abdeckung auf das Reinigungsmodul, eine den Grundkörper bedeckende Haube mit einem Schlitz zum Einführen der Halbleiterscheibe in das Reinigungsmodul und einen Bügel, der über den Schlitz verschiebbar an der Haube befestigt ist, gekennzeichnet durch eine erste Ablaufrinne, die parallel zum Schlitz und entlang einer dem Schlitz nahen Randbegrenzung des Bügels in eine obere Seitenfläche des Bügels eingearbeitet ist, und durch eine Blende, die über den Grundkörper und über den Schlitz verschiebbar ist, und durch eine zweite Ablaufrinne, die parallel zum Schlitz und entlang einer dem Schlitz nahen Randbegrenzung der Blende in eine obere Seitenfläche der Blende eingearbeitet ist. Der Bügel und die Blende werden gegeneinander geschoben, damit beim Ablegen oder Aufnehmen der Halbleiterscheibe mittels einer Greifvorrichtung die Breite des Schlitzes auf ein Maß beschränkt ist, das für Bewegungen der Greifvorrichtung notwendig ist.

## Beschreibung

Gegenstand der Erfindung ist eine Abdeckung für ein Reinigungsmodul zum Reinigen einer Halbleiterscheibe, in dem die Halbleiterscheibe vertikal ausgerichtet während eines Reinigungsschritts mit einer Flüssigkeit behandelt wird. Gegenstand der Erfindung ist auch ein Verfahren zum Reinigen einer Halbleiterscheibe in einer Reinigungsstrasse, die mindestens ein Reinigungsmodul mit einer solchen Abdeckung umfasst.

### Stand der Technik / Probleme

In US2006 0 254 715 A1 ist ein Verfahren beschrieben, mit dem eine Halbleiterscheibe zwischen nacheinander angeordneten Reinigungsmodulen einer Reinigungsstrasse transportiert werden, um sie in jedem der Reinigungsmodule einer Einzelscheiben-Reinigung zu unterziehen. Im Zuge dessen wird mindestens ein Roboter entlang einer Führung zu einem der Reinigungsmodule bewegt und ein Manipulator in das Reinigungsmodul abgesenkt, um die Halbleiterscheibe im Reinigungsmodul abzulegen oder aufzunehmen. Nachteilig daran ist, dass vom Manipulator oder der Halbleiterscheibe abtropfende Flüssigkeit in das Reinigungsmodul gelangen und den Erfolg des Reinigungsprozesses gefährden kann.

Gemäß US 2014/0209239 A1 kann ein Reinigungsmodul mit einer verschließbaren Abdeckung versehen sein. In geöffnetem Zustand soll die Abdeckung den Zugang zum Reinigungsmodul gewähren und in geschlossenem Zustand verhindern, dass während der Reinigung einer Halbleiterscheibe Flüssigkeit aus dem Reinigungsmodul in die Umgebung spritzt.

Aufgabe der vorliegenden Erfindung ist es, einzuschränken, dass Flüssigkeit unbeabsichtigt in die Reinigungsmodule gelangen kann.

Die Aufgabe der Erfindung wird gelöst durch eine Abdeckung für ein Reinigungsmodul zum Reinigen einer Halbleiterscheibe, in dem die Halbleiterscheibe vertikal ausgerichtet während eines Reinigungsschritts mit einer Flüssigkeit behandelt wird, umfassend einen Grundkörper mit keilförmigem Querschnitt, einen Abdichtrahmen zum Absetzen der Abdeckung auf das Reinigungsmodul, eine den Grundkörper bedeckende Haube mit einem Schlitz zum Einführen der Halbleiterscheibe in das Reinigungsmodul und einen Bügel, der über den Schlitz verschiebbar an der Haube befestigt ist, gekennzeichnet durch eine erste Ablaufrinne, die parallel zum Schlitz und entlang einer dem Schlitz nahen Randbegrenzung des Bügels in eine obere Seitenfläche des Bügels eingearbeitet ist, und durch eine Blende, die über den Grundkörper und über den Schlitz verschiebbar ist, und durch eine zweite Ablaufrinne, die parallel zum Schlitz und entlang einer dem Schlitz nahen Randbegrenzung der Blende in eine obere Seitenfläche der Blende eingearbeitet ist.

Die Blende, die über den Schlitz der Haube geschoben werden kann, und der Bügel werden eingesetzt, um die Breite des Schlitzes bei geöffnetem Schlitz soweit wie möglich zu reduzieren. Tropfen, die durch den Schlitz in das Reinigungsmodul fallen können, werden daran gehindert, sofern sie auf den Bügel oder die Blende treffen. Tropfen, die auf den Bügel oder auf die Blende fallen, werden mittels der ersten Ablaufrinne auf der oberen Seitenfläche des Bügels beziehungsweise der zweiten Ablaufrinne auf der oberen Seitenfläche der Blende vom Reinigungsmodul weg nach Außen abgeleitet.

Gegenstand der Erfindung ist auch ein Verfahren zum Reinigen einer Halbleiterscheibe in einer Reinigungsstrasse, die mindestens ein Reinigungsmodul umfasst, in dem eine vertikal ausgerichtete Hableiterscheibe während eines Reinigungsschritts mit einer Flüssigkeit des Reinigungsschritts behandelt wird, wobei ein Greifsystem zum Ablegen oder Aufnehmen der Halbleiterscheibe durch einen Schlitz einer Haube einer Abdeckung des Reinigungsmoduls in das Reinigungsmodul bewegt wird. Das Verfahren ist dadurch gekennzeichnet, dass das Reinigungsmodul mit einer erfindungsgemäßen Abdeckung versehen ist und der Bügel und die Blende gegeneinander geschoben werden, damit beim Ablegen oder Aufnehmen einer Halbleiterscheibe mittels einer Greifvorrichtung die Breite des Schlitzes auf ein Maß beschränkt ist, das für Bewegungen der Greifvorrichtung notwendig ist. Vorzugsweise wird sichergestellt, dass für solche Bewegungen hin zum Bügel oder zur Blende ein zusätzliches Spiel von nicht mehr als 2 mm vorhanden ist.

Vorzugsweise wird das Verfahren in einer Reinigungsstrasse verwendet, die zwei oder mehrere Reinigungsmodule umfasst, die jeweils mit einer erfindungsgemäßen Abdeckung versehen sind.

Die Erfindung wird nachfolgend an einem Ausführungsbeispiel unter Bezugnahme auf Zeichnungen beschrieben.

### Kurzbeschreibung der Figuren

**Fig. 1** zeigt eine perspektivische Ansicht einer erfindungsgemäßen Abdeckung.
**Fig. 2** zeigt eine Seitenansicht der Abdeckung.
**Fig. 3** zeigt die Abdeckung in Draufsicht.

### Liste der verwendeten Bezugszeichen

- **1**: Grundkörper
- **2**: Haube
- **3**: Schlitz
- **4**: Bügel
- **5**: Blende
- **6**: Hülse
- **7**: Führungsleiste
- **8**: Langloch
- **9**: Prallleiste
- **10**: Ablaufrinne
- **11**: Ablaufrinne
- **12**: Abdichtrahmen

### Detaillierte Beschreibung erfindungsgemäßer Ausführungsbeispiele

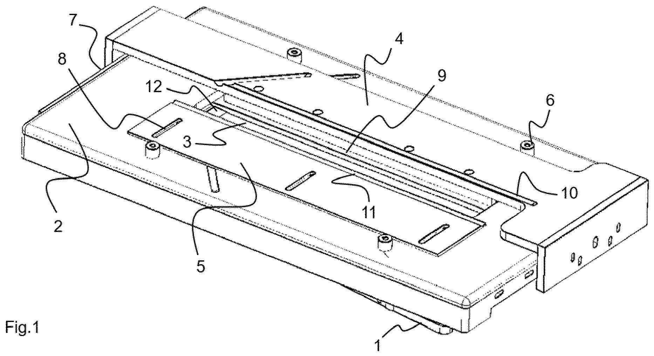

Die in Fig.1 gezeigte Abdeckung umfasst einen Grundkörper 1, einen Abdichtrahmen 12, eine Haube 2 mit einem Schlitz 3, einen Bügel 4 und eine Blende 5. Der Grundkörper 1 hat einen keilförmigen Querschnitt und sitzt mit Hilfe des Abdichtrahmens 12 auf einem Reinigungsmodul, das nicht dargestellt ist. Die Haube 2 mit einem Schlitz 3 zum Einführen der Halbleiterscheibe mittels einer Greifvorrichtung in das Reinigungsmodul ist mittels Hülsen 6 des Grundkörpers 1 auf dem Grundkörper 1 fixiert und bedeckt diesen. Im dargestellten geöffneten Zustand der Abdeckung flankieren den Schlitz 3 ein Bügel 4 auf einer Seite des Schlitzes 3 und eine Blende 5 auf der gegenüberliegenden Seite des Schlitzes 3. Der Bügel 4 ist über den Schlitz 3 verschiebbar an einer Führungsleiste 7 der Haube 2 befestigt. Der Bügel 4 kann soweit in Richtung des Schlitzes 3 verschoben werden, dass er diesen vollständig überdeckt und so die Abdeckung in einen geschlossenen Zustand versetzt. Die Blende 5 auf der anderen Seite des Schlitzes 3 verfügt über Langlöcher 8, entlang derer sie über den Schlitz 3 geschoben werden kann, um bei geöffnetem Zustand der Abdeckung die Breite des Schlitzes 3 einstellen zu können. Unterhalb der Haube 2 ist eine Prallleiste 9 angeordnet, die an der unteren Seite des Bügels 4 befestigt ist. Der Schlitz 3 wird in geöffnetem Zustand der Abdeckung von Ablaufrinnen 10, 11 flankiert. Die Ablaufrinne 10 ist nahe der dem Schlitz 3 benachbarten Randbegrenzung des Bügels 4 in die obere Seitenfläche des Bügels 4 eingearbeitet und parallel zum Schlitz 3 orientiert. Die Ablaufrinne 11 ist nahe der dem Schlitz 3 benachbarten Randbegrenzung der Blende in die obere Seitenfläche der Blende 5 eingearbeitet und parallel zum Schlitz 3 orientiert.

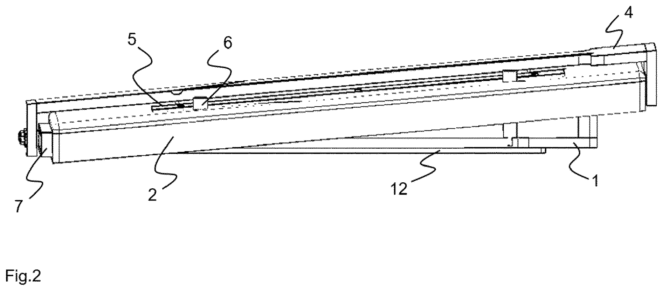

Fig.2 zeigt eine Seitenansicht der Abdeckung. Wegen des keilförmigen Querschnitts des Grundkörpers 1, besteht ein Gefälle hin zur Führungsleiste 7. Der Bügel 4 und die Blende 5 sind entsprechend diesem Gefälle geneigt, so dass Tropfen einer Flüssigkeit, die auf den Bügel 4 beziehungsweise die Blende 5 fallen entlang der Ablaufrinne 10 beziehungsweise Ablaufrinne 11 abgeleitet und damit gehindert werden, durch den Schlitz 3 in das Reinigungsmodul zu fallen.

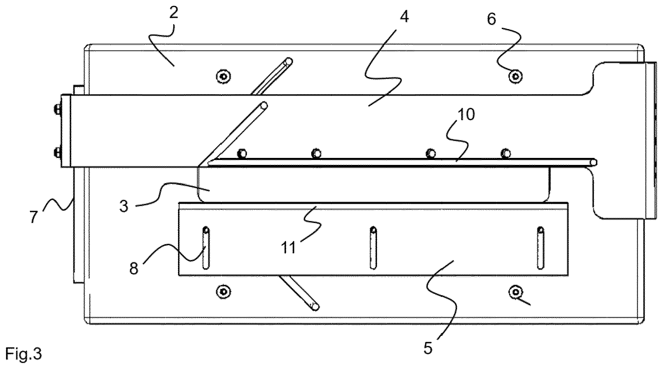

Fig.3 zeigt die Abdeckung in Draufsicht und zwar in geöffnetem Zustand. Die Breite des Schlitzes ist von der Länge des Verschiebewegs abhängig, entlang dessen der Bügel 4 und die Blende 5 über den Schlitz geschoben wurden. Der Bügel 4 und die Blende 5 werden gegeneinander geschoben, damit beim Ablegen oder Aufnehmen der Halbleiterscheibe mittels der Greifvorrichtung die Breite des Schlitzes auf ein Maß beschränkt ist, das für Bewegungen der Greifvorrichtung notwendig ist.

Die Möglichkeit, dass Flüssigkeit bei geöffnetem Zustand der Abdeckung unbeabsichtigt durch den Schlitz in das Reinigungsmodul gelangen kann, wird durch dieses Einstellen der Breite des Schlitzes wirksam eingeschränkt.

## Patentansprüche

1. Abdeckung für ein Reinigungsmodul zum Reinigen einer Halbleiterscheibe, in dem die Halbleiterscheibe vertikal ausgerichtet während eines Reinigungsschritts mit einer Flüssigkeit behandelt wird, umfassend einen Grundkörper mit keilförmigem Querschnitt, einen Abdichtrahmen zum Absetzen der Abdeckung auf das Reinigungsmodul, eine den Grundkörper bedeckende Haube mit einem Schlitz zum Einführen der Halbleiterscheibe in das Reinigungsmodul und einen Bügel, der über den Schlitz verschiebbar an der Haube befestigt ist, **gekennzeichnet durch** eine erste Ablaufrinne, die parallel zum Schlitz und entlang einer dem Schlitz nahen Randbegrenzung des Bügels in eine obere Seitenfläche des Bügels eingearbeitet ist, und durch eine Blende, die über den Grundkörper und über den Schlitz verschiebbar ist, und durch eine zweite Ablaufrinne, die parallel zum Schlitz und entlang einer dem Schlitz nahen Randbegrenzung der Blende in eine obere Seitenfläche der Blende eingearbeitet ist.

2. Verfahren zum Reinigen einer Halbleiterscheibe in einer Reinigungsstrasse, die mindestens ein Reinigungsmodul umfasst, in dem eine vertikal ausgerichtete Hableiterscheibe während eines Reinigungsschritts mit einer Flüssigkeit des Reinigungsschritts behandelt wird, wobei ein Greifsystem zum Ablegen oder Aufnehmen der Halbleiterscheibe durch einen Schlitz einer Haube einer Abdeckung des Reinigungsmoduls in das Reinigungsmodul bewegt wird, **dadurch gekennzeichnet, dass** das Reinigungsmodul mit einer Abdeckung gemäß Anspruch 1 versehen ist und der Bügel und die Blende gegeneinander geschoben werden, damit beim Ablegen oder Aufnehmen der Halbleiterscheibe mittels einer Greifvorrichtung die Breite des Schlitzes auf ein Maß beschränkt ist, das für Bewegungen der Greifvorrichtung notwendig ist.

3. Verfahren nach Anspruch 2, **dadurch gekennzeichnet, dass** sichergestellt wird, dass für die Bewegungen der Greifvorrichtung hin zum Bügel oder zur Blende ein zusätzliches Spiel von nicht mehr als 2 mm vorhanden ist.

4. Verfahren nach Anspruch 2 oder Anspruch 3, **dadurch gekennzeichnet, dass** die Reinigungsstrasse zwei oder mehrere Reinigungsmodule umfasst, die jeweils mit einer Abdeckung gemäß Anspruch 1 versehen sind.
